# EUROPEAN PATENT SPECIFICATION

(11) **EP 0 660 506 B1**
(45) Date of publication and mention of the grant of the patent: **03.03.1999**
(21) Application number: 94309268.4
(22) Date of filing: 12.12.1994
(51) Int. Cl.: H03D 3/24, H03B 5/18

(54) **FM Signal demodulator**
FM Signal-Demodulator
Démodulateur de signal FM

(30) Priority: 22.12.1993 JP 324919/93; 27.12.1993 JP 333382/93
(43) Date of publication of application: 28.06.1995
(73) Proprietor: MATSUSHITA ELECTRIC INDUSTRIAL CO., LTD., Kadoma-shi, Osaka-fu, 571 (JP)
(72) Inventor: Omoto, Noriaki, Takatsuki-shi, Osaka 569 (JP)
(74) Representative: Crawford, Andrew Birkby

(56) References cited:
- EP-A- 0 074 687
- EP-A- 0 351 153
- US-A- 4 107 624
- 1992 IEEE MTT-S INTERNATIONAL MICROWAVE SYMPOSIUM DIGEST, vol.2, 1 June 1992, ALBUQUERQUE pages 1085 - 1088, XP000343482 H. YABUKI ET AL. 'New Type of Push-Push Oscipliers for the Frequency Synthesizer'

## Description

### BACKGROUND OF THE INVENTION

### FIELD OF THE INVENTION

The present invention relates to an FM signal demodulator for demodulating a frequency modulated video signal widely used in a satellite television broadcast or the like. Means for easy adjustment and good mass-production and means for giving stable demodulation performance by reducing interference due to that an oscillation component drifts and leaks into the input stage.

### DESCRIPTION OF THE PRIOR ART

In a satellite television broadcast, frequency modulation (FM) is used for transmitting a video signal and this FM signal is demodulated at a 400MHz band which is a second intermediate frequency (IF). Recently, such a FM signal demodulator is usual to be formed by a phase locked loop and circuits are made into integrated circuits (IC) and miniaturization and reduction of power consumption for apparatus are planned.

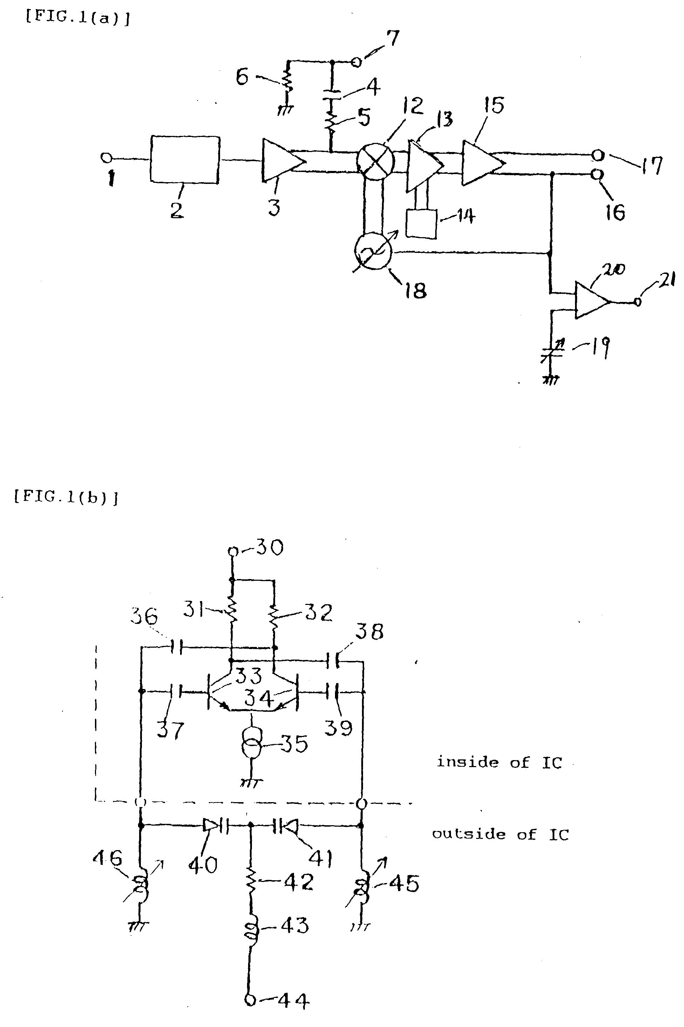

FIG.1(a) is a block diagram of an FM signal demodulator in accordance with the prior art. A wide band FM signal which the second IF is 400 MHz and is modulated by a video signal is supplied to a second IF input terminal 1. A surface acoustic wave (SAW) bandpass filter 2 called channel filter is used for removing signals outside the band and noise. A second IF amplifier 3 amplifies the selected signal to a desired level to demodulate the FM signal. The second IF amplifier 3 is an amplifier with a constant gain or a variable gain amplifier which is set to a desired gain by a control signal.

A phase comparator 12 detects a phase difference between an inputted FM signal and an output signal of a voltage controlled oscillator 18 and outputs a DC voltage corresponding to the phase difference. The output is a video signal including DC component and is supplied to demodulator output terminals 16 and 17 through a low pass filter composed of a first and a second differential amplifiers 13 and 15, respectively and is negatively feedbacked to the voltage controlled oscillator 18. Thus, a phase locked loop is formed.

The voltage controlled oscillator 18 is made into an IC by using a circuit shown in FIG.1(b) according to, for example EP-A-0351153. The DC source voltage for the voltage-controlled oscillator 18 is supplied from a terminal 30. Because a high level signal such as an oscillation signal is easy to give an interference to the other circuits inside the IC, balanced signals are usually used. Accordingly, a differential amplifier composed of transistors 33 and 34 is used and the balanced signals outputted from the collectors of the transistors 33 and 34 are supplied to the phase comparator 12. A series connection of capacitors 36 and 37 is connected from a collector of the transistor 34 to a base of the transistors 33 and another series connection of capacitors 38 and 39 is connected from a collector of the transistor 33 to a base of the transistors 34 and these connections give positive feedback to the transistors. An anode of a variable capacitance diode 40 and a terminal of an air-core coil 46 are connected to a junction of the capacitors 36 and 37. An anode of a variable capacitance diode 41 and a terminal of an air-core coil 45 are connected to a junction of the capacitors 38 and 39. Another terminals of the air-core coils 45 and 46 are grounded. Cathodes of the variable capacitance diodes 40 and 41 are connected each other and their junction is connected to a control terminal 44 through a series connection of a resistor 42 and an air-core coil 43.

The voltage controlled oscillator 18 oscillates at a resonance frequency of a resonant circuit composed of the variable capacitance diodes 40 and 41 and the air-core coils 45 and 46. The voltage controlled oscillator 18 is necessary to work as a frequency modulator controlled by a video signal demodulated output. Accordingly, it is desirable that an output impedance of the second differential amplifier 15 at the control terminal 44 is as low as possible to follow a video signal variation at the video signal frequency band of less than 10 MHz. In order to normally oscillate at a high second IF of 400 MHz, it is desirable that the impedance at the junction between the variable capacitance diodes 40 and 41 is high enough at the 400 MHz band. A high impedance is obtained by a series connection of the resistor 42 and the air-core coil 43.

Because the FM signal demodulator shown in FIG.1(a) forms a phase locked loop, the frequency of an inputted FM signal coincides with the oscillation frequency of the voltage controlled oscillator 18 at a synchronization state. When the second IF is a center frequency, because the output voltage of the second differential amplifier 15 becomes a center value of the demodulated output voltage, it is desirable that the second differential amplifier 15 is in an equilibrium state. Then, it is desirable that the output voltage is a center value of the dynamic range and the dynamic range of the demodulation characteristic is maximum.

It is desirable that for linearity of the oscillation frequency a control voltage of the voltage controlled oscillator 18 is best set at this voltage.

The oscillation frequency of the voltage controlled oscillator 18 is determined by the variable capacitance diodes 40 and 41 and the air-core coils 45 and 46. The variable capacitance diodes 40 and 41 usually have a capacitance spread of about +/-15 % when their cross terminal voltages are constant.

Due to this spread, the voltage controlled oscillator 18 does not always oscillate at the center frequency at the center of the output dynamic range of the second differential amplifier 15. Accordingly, in the prior art, the coil inductance is varied by widening or narrowing the winding gaps of the air-core coil 45 or 46 and thus, the oscillation frequency is adjusted by compensating the spread of the variable capacitance diodes so that the voltage controlled oscillator 18 oscillates at the center frequency at the center of the output dynamic range of the second differential amplifier 15.

A differential balance controller 14 adjusts the oscillation frequency of the voltage controlled oscillator 18 so that it coincides with the center frequency of the second IF frequency when the FM signal is not supplied to the phase comparator. Thus, a free running frequency of a phase locked loop type FM signal demodulator is adjusted.

Recently, almost all functions concerning to FM signal demodulation such as a second IF amplifier 3, a phase comparator 12, a second differential amplifier 15, a voltage controlled oscillator 18, a detector for an automatic frequency controller (AFC), a detector for an automatic gain controller (AGC) are integrated into an IC. Some developments are being progressed to include more peripheral circuit elements in an IC. There is a trend to increase a gain of the second IF amplifier 3 as high as possible and to increase input sensitivity of the IC.

The output signal of the demodulated output terminal 16 and the reference voltage 19 are supplied to a voltage comparator 20. Because the output voltage of the FM signal demodulator is proportional to the frequency of the inputted FM signal, frequency comparison can be done at the voltage comparator 20. The voltage of the reference voltage source 19 is adjusted to become a voltage corresponding to the frequency to be compared. Thus, the output signal at the output terminal 21 of the voltage comparator 20 can be used as a control voltage for AFC.

In the circuit configuration in accordance with the prior art, however, the modulated output voltage does not always come to the center of the dynamic range of the second differential amplifier 15 at the center frequency of the second IF, because of the capacitance spread of the variable capacitance diodes 40 and 41. Therefore, the oscillation frequency of the voltage controlled oscillator 18 is necessary to be adjusted and the adjustment is made by widening or narrowing the winding gaps of the air-core coils 45 and 46. But the adjustment of the air-core coils is not so easy as that of variable resistors and especially precise adjustment is actually remarkably difficult.

Further, in the circuit configuration in accordance with the prior art, although interference due to a drifting signal can be reduced, because the air-core coils 40 and 41 are inserted to a printed circuit board, the oscillation signal component is radiated from the air-core coils 40 and 41 to the rear surface of the board or in the air and leaks to the input of the FM signal demodulator and interference is easy to occur.

Because the input sensitivity of the IC is high as mentioned already, interference is easy to occur. Especially, as a channel filter, a SAW filter 2 is recently used for non-adjustment and for getting a good cutoff characteristic. The insertion loss of the filter is as much as about 25 dB. Because this insertion loss is much bigger than that of a usual LC filter (about 4 dB) and the output signal level is low, performance deterioration is promoted by drifting and leaking of the oscillation signal component.

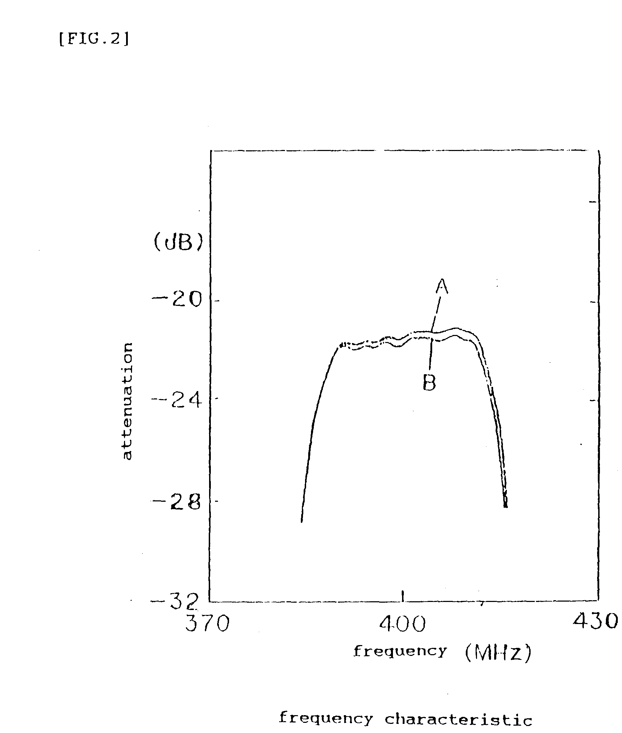

FIG.2 shows a frequency characteristic from the input terminal 1 to the monitor terminal 7 of the second IF signal shown in FIG.1. The waveform A is a characteristic when the voltage controlled oscillator 18 stops oscillation and the waveform B is that when the voltage controlled oscillator 18 normally oscillates and the phase locked loop synchronizes. Interference that the signal from the voltage-controlled oscillator 18 leaks to the input stage of the FM signal demodulator occurs and the waveform of the SAW bandpass filter 2 is disturbed. This is because the signal from the voltage controlled oscillator 18 synchronizing with the inputted FM signal leaks as an interference signal and is superposed on the original signal with a deviated phase and a deviated amplitude. Thus, a similar phenomenon to the phenomenon which occurs in a transmission system where multiple reflection occurs. As a result, the characteristics of the demodulated video signal such as differential gain, differential phase and the like are deteriorated.

US-A-4107624 discloses an automatic frequency tracking circuit which includes a phase locked loop and means incorporated in the loop which compensate or correct for any frequency drift in an incoming RF signal so as to maintain the loop locked onto the incoming signal. The correction means is responsive to low frequency components of a DC voltage produced by the detector for changing a bias voltage applied to the loop amplifier so as to main correct operation.

The present invention provides an FM signal demodulator comprising:
a voltage-controlled oscillator:
a phase comparator arranged to output a DC voltage corresponding to a phase difference between the phase of an input IF signal and the phase of an output of said voltage-controlled oscillator: and
a first differential amplifier arranged to output a demodulated signal which is negatively fed back to a control terminal of said voltage-controlled oscillator:
characterised by:
said voltage-controlled oscillator comprising a resonant circuit having a pair of capacitances. at least one of which is a variable capacitance diode, as resonant elements and a pair of micro strip lines having nearly equal length; and a second differential amplifier, the output of which is negatively fed-back through capacitors, arranged to vary an oscillating frequency according to the voltage supplied at said control terminal by controlling the voltage across said pair of capacitances of said resonant circuit; and by
further comprising a third differential amplifier arranged to amplify the output of said phase comparator and to provide an input to said first differential amplifier, said third differential amplifier being provided with a differential balance adjusting circuit arranged such that the free running frequency of said voltage controlled oscillator is the centre frequency of the expected IF signal when no IF signal is input to said phase comparator.

In this circuit configuration, because the voltage controlled oscillator oscillates in a state that the differential amplifier keeps differential balance, in-phase component hardly generates from the oscillation signal, and further by using micro strip lines, most oscillation power of the voltage-controlled oscillator exists inside the dielectric of the printed circuit board and hardly radiates in the air. Thus, interference caused by drifting and leaking of the oscillation power to the input side of the demodulator is reduced.

### BRIEF DESCRIPTION OF THE DRAWINGS

FIG.1(a) is a block diagram of an essential part of a phase locked loop type FM signal demodulator in accordance with the prior art.

FIG.1(b) is a circuit diagram of a voltage controlled oscillator 18 used in a phase locked loop type FM signal demodulator in accordance with the prior art.

FIG.2 shows a frequency characteristic from an input terminal 1 to a monitor terminal 7 for a second IF signal in a phase locked loop type FM signal demodulator in accordance with the prior art.

FIG.3(a) is a block diagram of an essential part of a first example phase locked loop type FM signal demodulator useful for understanding the present invention.

FIG.3(b) is a circuit diagram of a voltage controlled oscillator 18a used in a phase locked loop type FM signal demodulator in accordance with the first example.

FIG.4(a) is a circuit diagram of a second differential amplifier 15a used in a phase locked loop type FM signal demodulator in accordance with the first example.

FIG.4(b) shows an input-output voltage characteristic of a second differential amplifier 15a used in a phase locked loop type FM signal demodulator in accordance with the first example.

FIG.5(a) is a block diagram of an essential part of a second example phase locked loop type FM signal demodulator useful for understanding the present invention.

FIG.5(b) is a circuit diagram of a voltage-controlled oscillator 18b used in a phase locked loop type FM signal demodulator in accordance with the second example.

FIG.6 shows an input-output voltage characteristic of a second differential amplifier 15a used in a phase locked loop type FM signal demodulator in accordance with the second example.

FIG.7(a) is a block diagram of an essential part of a phase locked loop type FM signal demodulator in accordance with an exemplary embodiment of the present invention.

FIG.7(b) is a circuit diagram of a voltage controlled oscillator 18c used in a phase locked loop type FM signal demodulator in accordance with the exemplary embodiment of the present invention.

FIG.8 shows a frequency characteristic from an input terminal 1 to a monitor terminal 7 of a second IF signal in a phase locked loop type FM signal demodulator in accordance with the exemplary embodiment of the present invention.

### DETAILED DESCRIPTION OF THE INVENTION

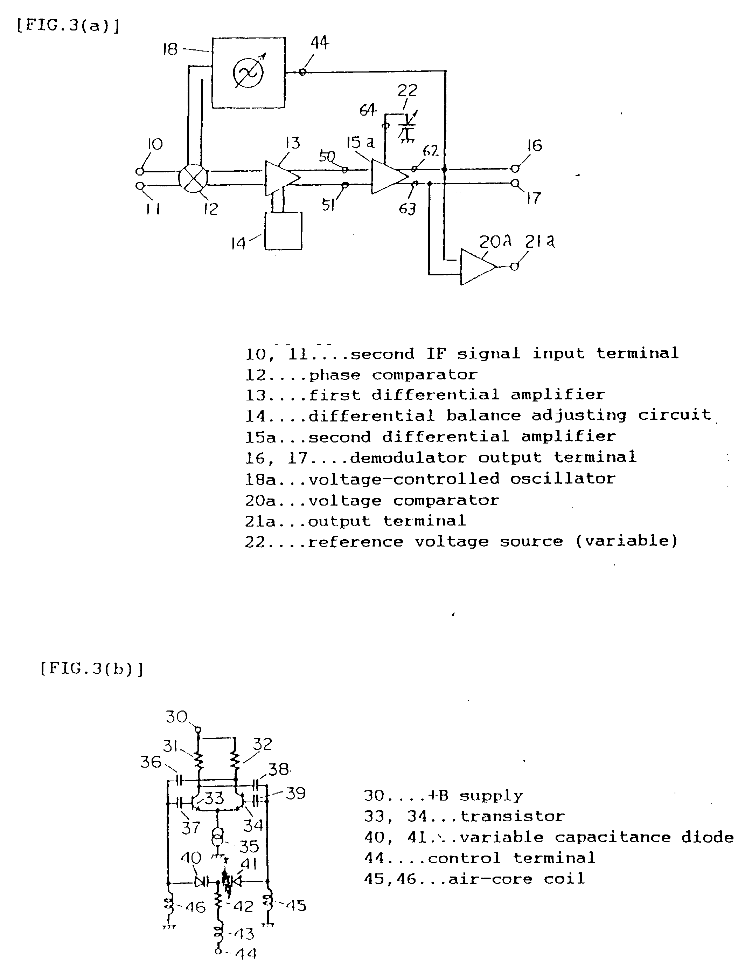

FIG.3(a) is a block diagram of an essential part of a first example phase locked loop type FM signal demodulator useful for understanding the present invention. A phase comparator 12, a first differential amplifier 13, a differential balance adjustong circuit 14 and a voltage-controlled oscillator 18 have similar functions to those in the prior art shown in FIG.1(a) and their detailed explanations are omitted.

A variable reference voltage is supplied from a reference voltage source 22 to a second differential amplifier 15a. Two input terminals of a voltage comparator 20a are connected to balanced demodulator output terminals 16 and 17 of the second differential amplifier 15a to get outputs proportional to the output difference between the demodulator output terminals 16 and 17 at a terminal 21a. The demodulator output terminal 16 is connected to a control terminal 44 of a voltage-controlled oscillator 18a to form a negative feedback loop and thus, a phase locked loop is formed.

FIG.3(b) is a circuit diagram of the voltage-controlled oscillator 18a and the circuit elements having similar functions to those in FIG.1(b) are numbered with the same reference numbers and their detailed explanations are omitted.

The voltage-controlled oscillator 18a oscillates at a resonance frequency determined by a resonant circuit composed of variable capacitance diodes 40 and 41 and air-core coils 45 and 46 similarly to that of the prior art. The voltage-controlled oscillator 18a is necessary to work as a frequency modulator controlled by a demodulated video signal output. Therefore, at the video frequency band under 10 MHz, the output impedance of the second differential amplifier 15a seen from the control terminal 44 is desirable to be as low as possible to follow the video signal variation. To normally oscillate at a second IF frequency of 400 MHz, the impedance at the junction point between the variable capacitance diodes 40 and 41 looking towards the control terminal 44 is desirable to be high enough at the 400 MHz band. Therefore, a high impedance is provided by a series connection of a resistor 42 and an air-core coil 43.

Here, the capacitors 36, 38 and 37, 39 are selected to have the same capacitance as large as nearly 3 pF. It is sufficient that the resistor 42 is 39 ohms and the inductance of the air-core coil 43 is 120 nH.

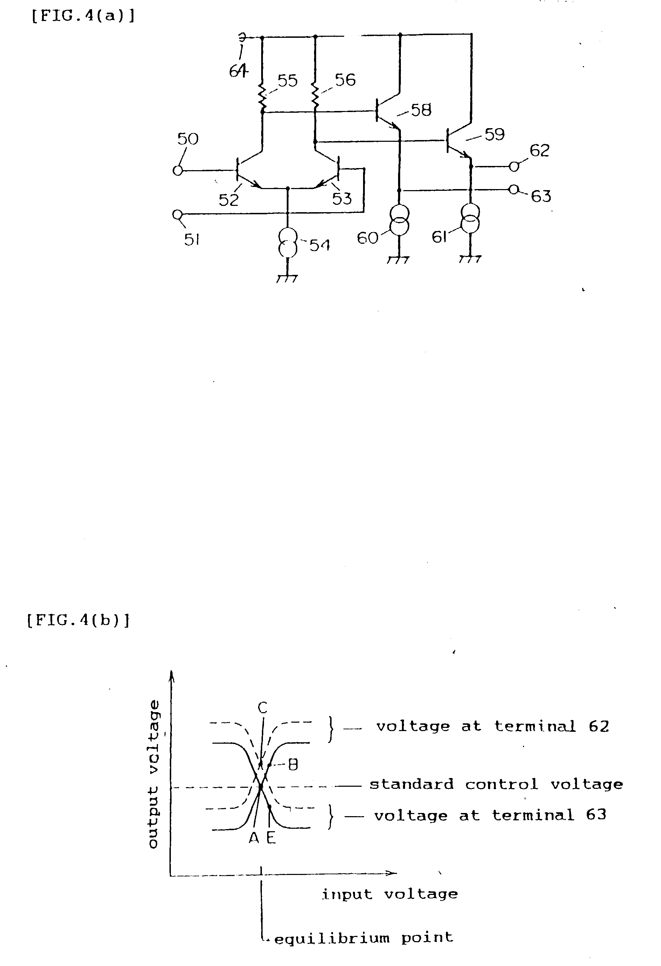

A circuit diagram of the second differential amplifier 15a is shown in FIG.4(a).

The differential amplifier 15a is a DC amplifier amplifying phase difference signal including a video signal and is composed of a differential amplifier composed of transistors 52 and 53 followed by buffer amplifiers composed of transistors 58 and 59. The differential amplifier 15a amplifies the inputted phase difference signal and outputs the signal at a low impedance after adjusting the in-phase signal level to an adequate level by a variable reference voltage source 22.

FIG.4(b) is an input-output voltage characteristic of the second differential amplifier 15a. In FIG.3(a), a wide band FM signal modulated by a video signal is supplied from input terminals 10 and 11 of the second IF signal to a phase comparator 12 as a second IF signal of 400 MHz. The phase comparator 12 detects a phase difference between the frequency modulated input signal and the output signal of the voltage controlled oscillator 18a and outputs a DC voltage corresponding to the phase difference. The DC signal is outputted to the demodulator output terminals 16 and 17 through a low pass filter composed of a first differential amplifier 13 and the second differential amplifier 15a and at the same time it is negatively feedbacked to the voltage-controlled oscillator 18a. Thus, a phase locked loop is formed.

When the center frequency signal of the second IF is supplied to a phase locked loop as described above, the voltage-controlled oscillator 18a oscillates at the center frequency of the second IF, being phase locked. However, because the variable capacitance diodes 40 and 41 usually have a capacitance spread of about +/-15 % for a constant cross terminal voltage, the characteristic of the oscillation frequency against the cross terminal voltage is not constant. That is, the output voltage of the second differential amplifier 15a varies and the second differential amplifier 15a is not always in equilibrium. This is explained in the following using FIG.4(b).

When the capacitance values of the variable capacitance diodes 40 and 41 are the standard value, the voltage-controlled oscillator 18a oscillates at a center frequency of the second IF at the standard control voltage and the working point is the point A as shown in FIG.4(b).

When the capacitance values of both variable capacitance diodes 40 and 41 are larger than a standard value, it is necessary to supply a higher control voltage than the standard voltage to the control terminal 44 in order that the voltage-controlled oscillator 18a oscillates at the center frequency of the second IF. Therefore, the second differential amplifier 15a goes out of equilibrium and the working point comes to the point B shown in FIG.4(b). At this time, a voltage corresponding to an output difference between the terminals 62 and 63, that is the demodulator output terminal 16 and 17 at the output terminal 21a of the voltage comparator 20a.

Accordingly, if the voltage of the reference voltage source 22 which gives a supply voltage to the second differential amplifier 15a is adjusted to be higher and the output voltage at the equilibrium point of the input voltage is adjusted to be higher, the working point comes to the point C. At this time, the second differential amplifier 15a is in equilibrium. In an actual adjustment, the voltages at the terminals 62 and 63 are supplied to the voltage comparator 20a and the voltage of the reference voltage source 22 is adjusted so that the voltage difference between the working points B and E is minimum. The voltage comparison output from the output terminal 21a of the voltage comparator 20a can be used as a control voltage of an automatic frequency control (AFC) circuit. If some dead zone is necessary for controlling the AFC circuit, two voltage comparators which have an input voltage comparoison characteristic which deviates a little bit from the equilibrium may be used. In this case, a range of +/- 150kHz from the second IF is usually selected as the dead zone.

Actually, in the FM signal demodulator, the voltage of the reference voltage source 22 in the second differential amplifier 15a is adjusted. The oscillation frequency of the voltage-controlled oscillator 18a is made to be the center frequency at the equilibrium condition of the second differential amplifier 15a.

The differential balance adjusting circuit 14 is adjusted so that when the FM signal is not supplied to the input terminals 10 and 11, the voltage-controlled oscillator 18a oscillates at the center frequency of the second IF. This is free running frequency adjustment of a phase locked loop type FM signal demodulator.

According to this example the FM signal demodulator can be easily adjusted by adjusting the voltage of the reference voltage source 22 without adjusting the air-core coils 45 and 46 of the voltage-controlled oscillator 18 which is troublesome and difficult to adjust. Further, the working point of the differential amplifier can be kept on the center of the dynamic range and the dynamic range can be wide even in a low voltage circuit.

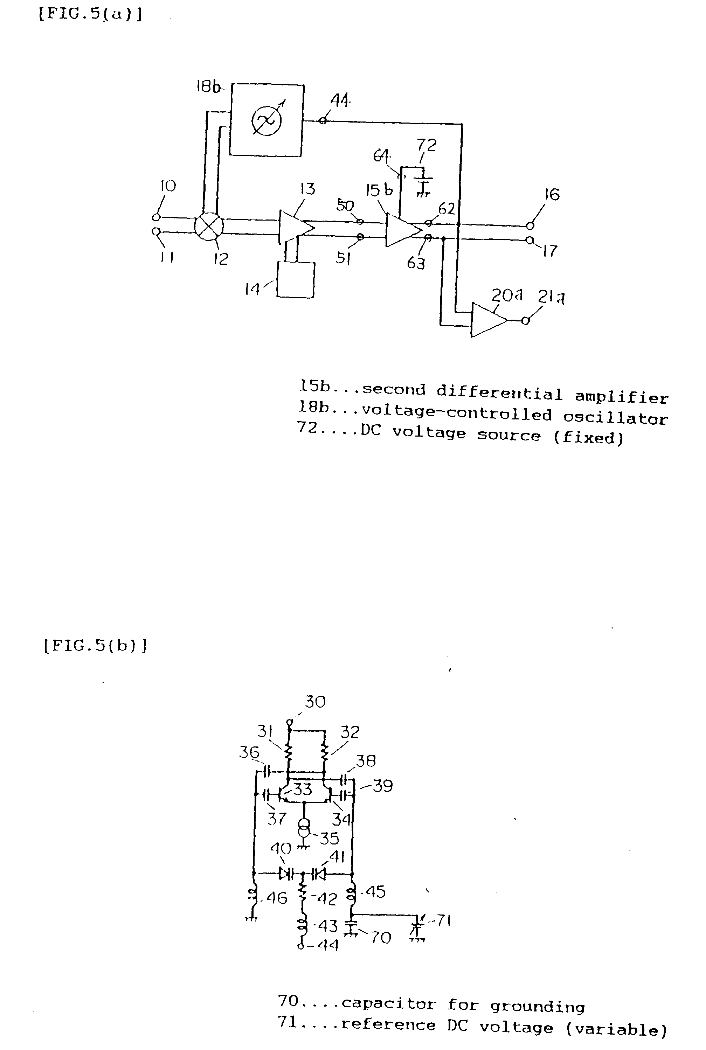

FIG.5(a) is a block diagram of an essential part of a second example phase locked loop type FM signal demodulator useful for understanding the present invention. The blocks having similar functions to those in FIG.3(a) are numbered with the same reference numbers and their explanations are omitted.

A voltage source is supplied from a constant voltage source 72 to a second differential amplifier 15b, different from the first exemplary embodiment. Two input terminals of a voltage comparator 20a are connected to demodulator output terminals 16 and 17 of the second differential amplifier 15b so that an output which is proportional to the difference between the outputs at the demodulator output terminals 16 and 17 is obtained at an output terminal 21a of the voltage comparator 20a.

In a voltage-controlled oscillator 18b shown in FIG.5(b), the circuit elements having similar functions to those in FIG.3(b) are numbered with the same reference numbers and their explanations are omitted. The different point from FIG.3(b) is in the resonant circuit. The ground side terminal of an air-core coil 45 is grounded by a parallel connection of a capacitor 70 and a variable reference DC voltage. The capacitor 70 is necessary to have a sufficiently low impedance at 400 MHz (second IF frequency of a satellite broadcast receiver). The oscillating frequency is adjusted by finely adjusting the cross terminal voltages of the variable capacitance diodes by the variable reference voltage 17.

The differential amplifier 15a has the quite same circuit as that in FIG.4(a) but it is connected to a fixed DC voltage source 72 instead of a variable DC voltage 22.

A constant voltage source 72 is supplied to a second differential amplifier 15b, being different from the first exemplary embodiment. Two input terminals of a voltage comparator 20a are connected to demodulator output terminals 16 and 17 of the second differential amplifier 15b so that an output which is proportional to the difference between the outputs at the demodulator output terminals 16 and 17 is obtained at an output terminal 21a of the voltage comparator 20a.

In a voltage-controlled oscillator 18b shown in FIG.5(b), the circuit elements having similar functions to those in FIG.3(b) are numbered with the same reference numbers and their explanations are omitted. The different point from FIG.3(b) is in the resonant circuit. The ground side terminal of an air-core coil 45 is grounded by a parallel connection of a capacitor 70 and a variable reference DC voltage. The capacitor 70 is necessary to have a sufficiently low impedance at 400 MHz (second IF frequency of a satellite broadcast receiver). The oscillating frequency is adjusted by finely adjusting the cross terminal voltages of the variable capacitance diodes 40 and 41 by the variable reference voltage 17.

The differential amplifier 15a has a quite same circuit as that in FIG.4(a) but it is connected to a fixed DC voltage source 72 instead of a variable DC voltage 22.

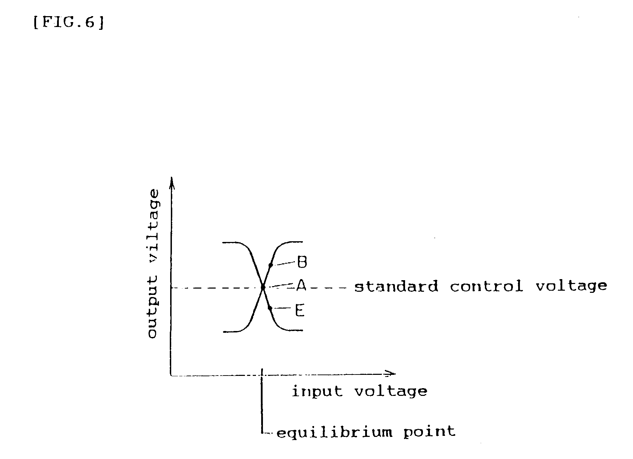

FIG.6 shows an input-output voltage characteristic of a second differential amplifier 15a used in the phase locked loop type FM signal demodulator shown in FIG.5(a).

In FIG.5(a), when the center frequency of the second IF signal is inputted from the terminals 10 and 11 to the phase locked type FM signal demodulator, the voltage-controlled oscillator 18b is phase-locked and oscillates at the center frequency of the second IF signal. However, because the variable capacitance diodes 40 and 41 usually have capacitance spread of +/-15 % at a constant cross terminal voltage as described before, the oscillating frequency characteristic against the cross terminal voltage is not constant. That is, the output voltage of the differential amplifier 15a varies and it does not always keep equilibrium.

As shown in FIG.6, the voltage-controlled oscillator 18b oscillates at a center frequency of the second IF signal at the standard control voltage, when the variable capacitance diodes 40 and 41 have a standard capacitance value. Accordingly, the working point comes to the point A.

However, when both of the variable capacitance diodes 40 and 41 have capacitance values larger than the standard value, it is necessary to supply a higher voltage than the standard to the control terminal 44 in order that the voltage-controlled oscillator 18b oscillates at the center frequency of the second IF signal. Accordingly, the second differential amplifier 15a moves out of equilibrium and the working point comes to the point B. At this time, at the output terminal 21a of the voltage comparator 20a, a voltage corresponding to the output difference between at the terminals 62 and 63, that is the demodulator output terminals 16 and 17, is outputted.

If the reference voltage 71 of the voltage-controlled oscillator 18b is decreased lower than the standard, that is if the cathode potential of the variable capacitance diode 41 is adjusted to be relatively higher, the working point returns to the point A and the second differential amplifier 15a comes in equilibrium. In an actual adjustment, the voltages of the terminals 62 and 63 are inputted to the voltage comparator 20a and the voltage of the reference voltage source 71 is adjusted so that the voltage difference between the working points B and E becomes minimum. The voltage comparison output from the output terminal 21a of the voltage comparator 20a obtained at this time can be used as a control voltage for an automatic frequency control circuit. In this arrangement it is possible to provide a dead zone similarly to the first example. The differential balance adjusting circuit 14 is also adjusted similarly to the first example.

Thus, also in the second example, the FM signal demodulator can be easily adjusted by adjusting the voltage of the reference voltage source 71 without adjusting the air-core coils 45 and 46 of the voltage-controlled oscillator 18 which is troublesome in the prior art.

Further, the working point of the differential amplifier can be kept at the center of the dynamic range and the dynamic range can be widened also in a low voltage circuit.

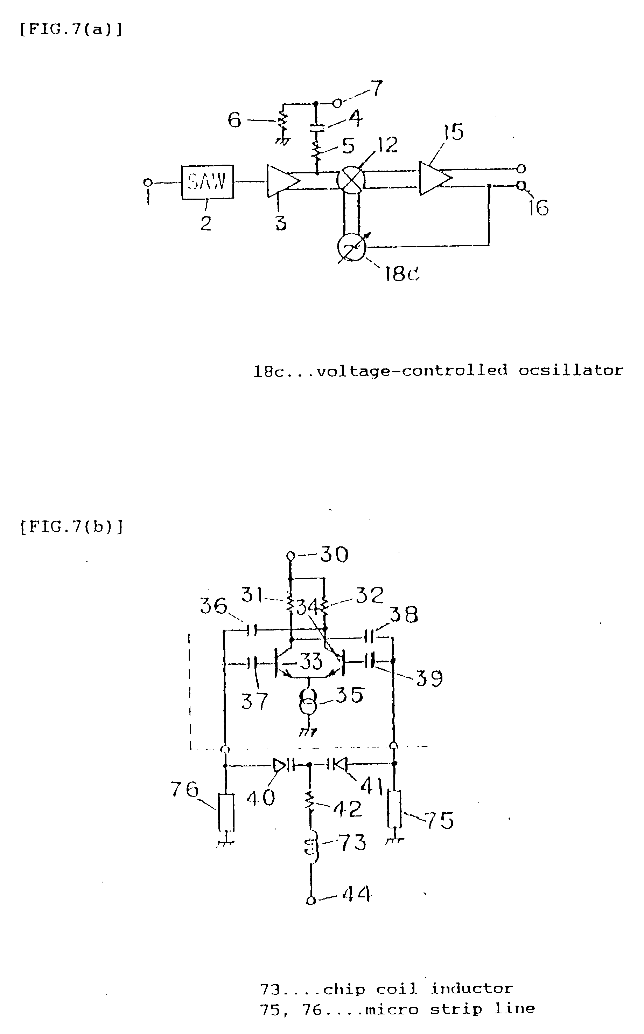

FIG.7(a) is a block diagram of an essential part of a phase locked loop type FM signal demodulator in accordance with an embodiment of the present invention. The blocks having similar functions to those in FIG.3(a) and FIG.5(a) are numbered with the same reference numbers and the blocks having similar functions to those in FIG.1(a) of the prior art such as a second IF signal input terminal 1, a SAW bandpass filter 2 and a second IF amplifier 3 are numbered with the same reference numbers and their explanations are omitted.

FIG.7(b) is a circuit diagram of a voltage-controlled oscillator 18c. Also in FIG,7(b), the circuit elements having similar functions to those in FIG.3(a) are numbered with the same reference numbers and their explanations are omitted. The different points from FIG.3(b) are that micro strip lines 75 and 76 are used instead of air-core coils 45 and 46 and a chip coil inductor 73 is used instead of an air-core coil 43.

A resonant circuit composed of the variable capacitance diodes 40 and 41 and the micro strip lines 75 and 76 oscillates at its intrinsic resonant frequency. If the capacitances of the variable capacitance diodes 40 and 41 and length of the micro strip lines 75 and 76 are selected nearly equal each other, the differential amplifier 18c oscillates keeping differential balance. Because the oscillation circuit becomes symmetry, the voltages at the cathodes of the variable capacitance diodes 40 and 41 have reverse phases and nearly equal amplitudes.

Further, because the junction point between the variable capacitance diodes 40 and 41 becomes an imaginary ground point for the differential amplifier 18c composed of the transistors 33 and 34, the stability of the oscillation state is hardly affected even if a video signal is applied at this point from the outside and the differential amplifier 18c is modulated.

Similarly to the first and the second examples, at the voltage-controlled oscillator 18c, it is desirable that the output impedance of the differential amplifier 15 seen from the control terminal 44 is as low as possible at the video frequency band lower than 10 MHz and the impedance of the control terminal 44 seen from the junction point of the variable capacitance diodes 40 and 41 is high enough at the second IF of 400 MHz.

In this embodiment, a chip coil inductor 73 is used instead of an air-core coil 43. The inductance of the chip coil inductor is sufficient to be nearly 120 nH. An air-core coil could however be used instead of a chip coil inductor.

In a printed micro strip line, electromagnetic field easily concentrates between the ground pattern on the back side of the printed circuit board and the micro strip line on the face side of the printed circuit board. Therefore, most oscilltion power of the voltage-controlled oscillator 18c exsists inside the dielectric of the printed circuit board and beneath the micro strip lines and hardly radiates in the air, differently from that air-core coils do. Especially, if spiral lines are used instead of strip lines, the concentration of the electromagnetic field increases and the effect will increase.

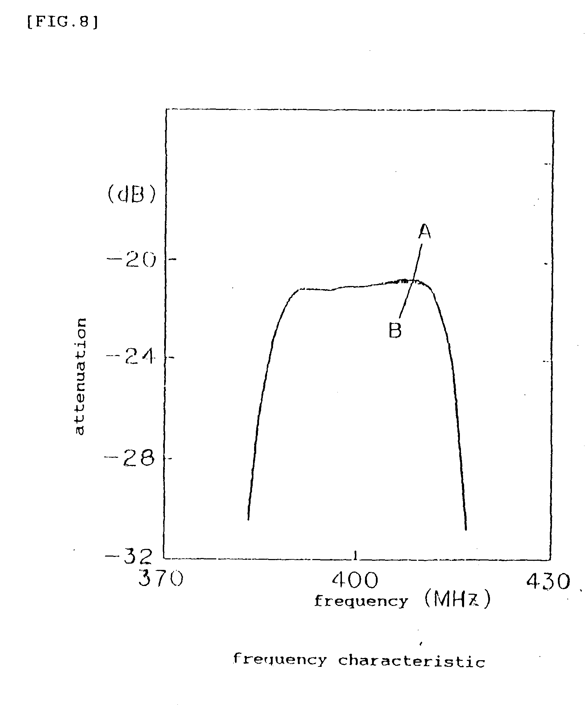

FIG.8 shows a frequency characteristic actually measured from an input terminal 1 to a monitor terminal 7 of a second IF signal in a phase locked loop type FM signal demodulator in accordance with this embodiment of the present invention. The characteristic A was measured in the state which the voltage-controlled oscillator 18c does not oscillate and the characteristic B was measured in the state which the voltage-controlled oscillator 18c normally oscillates and the phase locked loop is locked.

Although interference which the signal of the voltage-controlled oscillator 18c drifts and leaks into the input stage of the FM signal demodulator and the waveform of the SAW bandpass filter is a little disturbed but the interference is found to be extremely improved compared with the prior art.

In the satellite broadcast transmission standards, the video signal demodulated using the FM signal demodulator was measured to have good characteristics that its differential gain was less than 1 % and its differential phase was less than 1 degree. The modulation sensitivity (variation of the oscillating frequency against the control voltage) of the voltage-controlled oscillator 18c was measured as about 20 MHz/V and the signal to noise ratio of the video signal was measured as larger than 65 dB and all of them is a sufficient value.

In the embodiment described above, two variable capacitance diodes are used and it is considered that the differential function of the voltage-controlled oscillator is as perfect as possible. But one of two variable capacitance diodes is replaceable by a chip capacitor having nearly same capacitance. It has no problem because the oscillating frequency is 400 MHz which is high enough and the working frequency band width is only 27 MHz which is for one channel and it is important to keep linearity between the oscillating frequency and the control voltage at the working frequency band. The higher the modulation sensitivity is, the smaller the amplitude of the control voltage is. It is easier to get a good linearity of the control voltage and the dynamic range of the differential amplifier is allowed to be narrow. But if the modulation sensitivity is larger than 40 MHz, the signal to noise ratio of the demodulator output gets worse. Therefore, it is sometimes rather preferable to use one variable capacitance diode.

The most important thing is to get a good linearity of an oscillating frequency against a control voltage by carefully selecting the capacitance-voltage characteristic of a variable capacitance diode. As means for getting good linearity of the capacitance-voltage characteristic, a chip capacitor having an adequate capacitance value is selected.

Thus, according to the exemplary embodiment, an FM signal demodulator can be realized which prevents interference due to drifting and leaking of the oscillation power of the voltage-controlled oscillator to the input stage of the FM signal demodulator and has a stable demodulation characteristic.

The above-mentioned exemplary embodiment is not restricted to the use for satellite broadcast reception and is applicable for all demodulators for an FM signal.

## Claims

1. An FM signal demodulator comprising:
a voltage-controlled oscillator (18c);
a phase comparator (12) arranged to output a DC voltage corresponding to a phase difference between the phase of an input IF signal and the phase of an output of said voltage-controlled oscillator (18c); and
a first differential amplifier (15) arranged to output a demodulated signal which is negatively fed back to a control terminal (44) of said voltage-controlled oscillator (18c);
characterised by:
said voltage-controlled oscillator (18c) comprising a resonant circuit having a pair of capacitances (40,41), at least one of which is a variable capacitance diode, as resonant elements and a pair of micro strip lines (75,76) having nearly equal length; and a second differential amplifier (33,34), the output of which is negatively fed-back through capacitors, arranged to vary an oscillating frequency according to the voltage supplied at said control terminal (44) by controlling the voltage across said pair of capacitances of said resonant circuit; and by
further comprising a third differential amplifier (13) arranged to amplifv the output of said phase comparator (12) and to provide an input to said first differential amplifier (15), said third differential amplifier (13) being provided with a differential balance adjusting circuit (14) arranged such that the free running frequency of said voltage controlled oscillator (18c) is the centre frequency of the expected IF signal when no IF signal is input to said phase comparator (12).

2. An FM signal demodulator according to Claim 1 in which said capacitances of said resonant circuit are a pair of variable capacitances diodes (40,41).

3. An FM signal demodulator according to Claim 1 in which said capacitances of said resonant circuit are a variable capacitance diode and a fixed capacitor.

4. An FM signal demodulator as recited in Claim 1-3 wherein: balanced output signals of said first differential amplifier (15) are supplied to the two input terminals of a voltage comparator (20).

## Patentansprüche

1. Ein FM Signal-Demodulator, der umfaßt:
einen spannungsgesteuerten Oszillator (18c),
einen Phasenvergleicher (12), der ausgebildet ist, eine Gleichspannung entsprechend einer Phasendifferenz zwischen der Phase eines eingegebenen ZF Signals und der Phase eines Ausgangs des genannten spannungsgesteuerten Oszillators (18c) auszugeben; und
einen ersten Differenzverstärker (15), der ausgebildet ist, ein demoduliertes Signal auszugeben, das zu einer Steuerklemme (44) des genannten spannungsgesteuerten Oszillators (18c) negativ rückgekoppelt wird;
**dadurch gekennzeichnet**, daß
der genannte spannungsgesteuerte Oszillator (18c) eine Resonanzschaltung mit einem Paar Kapazitäten (40, 41) als Resonanzelemente umfaßt, von denen zu mindestens eine eine veränderbare Kapazitätsdiode ist, und ein Paar Mikrostreifenleitungen (75, 76) nahezu gleicher Länge aufweist; und daß ein zweiter Differenzverstärker (33, 34), dessen Ausgang durch Kondensatoren negativ rückgekoppelt wird, ausgebildet ist, eine Schwingungsfrequenz gemäß der der genannten Steuerklemme (44) zugeführten Spannung zu verändern, indem die Spannung über das genannte Paar Kapazitäten der genannten Resonanzschaltung gesteuert wird; und daß
des weiteren ein dritter Differenzverstärker (13) enthalten ist, der ausgestaltet ist, den Ausgang des genannten Phasenvergleichers (12) zu verstärken und einen Eingang für den genannten ersten Differenzverstärker (15) zu liefern, wobei der genannte dritte Differenzverstärker (13) mit einer Differenzausgleichseinstellschaltung (14) versehen ist, die so ausgebildet ist, daß die freilaufende Frequenz des genannten spannungsgesteuerten Oszillators (18c) die Mittenfrequenz des erwarteten ZF Signals ist, wenn kein ZF Signal dem genannten Phasenvergleicher (12) eingegeben wird.

2. Ein FM Signal-Demodulator gemäß Anspruch 1, bei dem die Kapazitäten des genannten Resonanzkreises ein Paar veränderbarer Kapazitätsdioden (40, 41) sind.

3. Ein FM Signal-Demodulator gemäß Anspruch 1, bei dem die genannten Kapazitäten der genannten Resonanzschaltung eine veränderbare Kapazitätsdiode und ein fester Kondensator sind.

4. Ein FM Signal-Demodulator wie in Anspruch 1 bis 3 genannte, bei dem die ausgeglichenen Ausgangssignale des genannten ersten Differenzempfängers (15) den zwei Eingangsklemmen eines Spannungsvergleichers (20) zugeführt werden.

## Revendications

1. Démodulateur de signal de modulation de fréquence comprenant :
un oscillateur commandé en tension (18c) ;
un comparateur de phases (12) agencé de manière à sortir une tension continue correspondant à une différence de phase entre la phase d'un signal de fréquence intermédiaire entré et la phase d'une sortie dudit oscillateur commandé en tension (18c) ; et
un premier amplificateur différentiel (15) agencé de manière à sortir un signal démodulé qui est renvoyé négativement à une borne de commande (44) dudit oscillateur commandé en tension (18c) ;
caractérisé par :
ledit oscillateur commandé en tension (18c) comprenant un circuit résonnant comportant deux capacitances (40, 41), l'une d'elles au moins étant une diode à capacitance variable, en tant qu'éléments résonnants, et deux lignes micro-ruban (75, 76), pratiquement de même longueur, et un second amplificateur différentiel (33, 34), dont la sortie est renvoyée négativement à travers des condensateurs, agencés de manière à faire varier une fréquence d'oscillation en fonction de la tension délivrée à ladite borne de commande (44) en contrôlant la tension aux bornes de ladite paire de capacitances dudit circuit résonnant ; et par
le fait qu'il comprend, de plus, un troisième amplificateur différentiel (13) agencé de manière à amplifier la sortie dudit comparateur de phases (12) et à fournir une entrée vers ledit premier amplificateur différentiel (15), ledit troisième amplificateur différentiel (13) étant pourvu d'un circuit d'ajustement d'équilibre différentiel (14) agencé de sorte que la fréquence de fonctionnement libre dudit oscillateur commandé en tension (18c) soit la fréquence centrale du signal de fréquence intermédiaire voulu lorsque aucun signal de fréquence intermédiaire n'est appliqué audit comparateur de phases (12).

2. Démodulateur de signal de modulation de fréquence selon la revendication 1, dans lequel lesdites capacitances dudit circuit résonnant sont deux diodes à capacitance variable (40, 41).

3. Démodulateur de signal de modulation de fréquence selon la revendication 1, dans lequel lesdites capacitances dudit circuit résonnant sont une diode à capacitance variable et un condensateur fixe.

4. Démodulateur de signal de modulation de fréquence selon les revendications 1-3, dans lequel :
les signaux de sortie équilibrés dudit premier amplificateur différentiel (15) sont délivrés aux deux bornes d'entrée d'un comparateur de tensions (20).
